(19) Europäisches Patentamt
European Patent Office
Office européen des brevets

(11) **EP 3 594 705 B1**

(12) **EUROPEAN PATENT SPECIFICATION**

(45) Date of publication and mention of the grant of the patent:
**28.04.2021 Bulletin 2021/17**

(21) Application number: **18764340.8**

(22) Date of filing: **08.03.2018**

(51) Int Cl.:
***G01R 31/392*** (2019.01)

(86) International application number:
**PCT/CN2018/078409**

(87) International publication number:
**WO 2018/161935 (13.09.2018 Gazette 2018/37)**

(54) **METHOD AND DEVICE FOR ESTIMATING SERVICE CAPACITY AND STATE OF HEALTH OF MINIMUM BATTERY CELL AND BATTERY SYSTEM**

VERFAHREN UND VORRICHTUNG ZUR SCHÄTZUNG DER DIENSTKAPAZITÄT UND DES GESUNDHEITSZUSTANDES EINER ZELLE MIT MINIMALER SPANNUNG UND EINES BATTERIESYSTEM

PROCÉDÉ ET DISPOSITIF D'ESTIMATION DE LA CAPACITÉ DE SERVICE ET DE L'ÉTAT DE SANTÉ D'UNE CELLULE A TENSION MINIMUM ET D'UN SYSTÈME DE BATTERIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.03.2017 CN 201710138750**

(43) Date of publication of application:
**15.01.2020 Bulletin 2020/03**

(73) Proprietor: **Zhengzhou Yutong Bus Co., Ltd.**
**Zhengzhou, Henan 450061 (CN)**

(72) Inventors:
• **ZHU, Guanghai**
  **Zhengzhou**
  **Henan 450061 (CN)**
• **YOU, Xianglong**
  **Zhengzhou**
  **Henan 450061 (CN)**

• **ZHANG, Hongtao**
  **Zhengzhou**
  **Henan 450061 (CN)**
• **ZHOU, Xuesong**
  **Zhengzhou**
  **Henan 450061 (CN)**
• **LI, Xiaofei**
  **Zhengzhou**
  **Henan 450061 (CN)**

(74) Representative: **Gulde & Partner**
**Patent- und Rechtsanwaltskanzlei mbB**
**Wallstraße 58/59**
**10179 Berlin (DE)**

(56) References cited:
| | |
|---|---|
| WO-A1-2015/025212 | CN-A- 101 706 556 |
| CN-A- 103 399 277 | CN-A- 103 513 187 |
| CN-A- 104 101 838 | CN-A- 105 574 224 |
| US-A1- 2003 214 303 | US-A1- 2012 296 586 |
| US-A1- 2016 349 329 | |

**Description**

**TECHNICAL FIELD**

The present disclosure belongs to the technical field of power battery management of new energy vehicles, and specifically relates to a method and a device for estimating a service capacity and a state of health of a minimum battery cell and a battery system.

**BACKGROUND**

Energy crisis and environmental pollution necessitate the acceleration and boosting of the development of new energy vehicles. New energy vehicles are crucial to promote the sustainable development of the automobile industry. With the release of the "China Energy-Saving and New Energy Vehicles Industry Development Program (2012-2020)" by the General Office of the State Council, automobile manufacturers have taken the development of new energy vehicles as an important part of the company's business and attached great importance to it . New energy vehicles have been greatly developed because of the advantages of new energy industry and the new subsidies and new policies issued by the national ministries and commissions.

As a key core component of new energy vehicles, power battery is the only power source for electric vehicles, playing an irreplaceable role in the development and operation of new energy vehicles. A power battery is always used under varying working conditions, complex environment, and harsh areas, which are factors that induce a great challenge to the power battery by impacting battery life and state of health of the battery. Accurately predicting the state of health of a battery is important for predicting the ageing of the battery, calculating battery life, and calculating a state of charge (SOC) and a power limit which are core functions of a battery management system. In addition, the determination of the state of health (SOH) of a battery is also an important indicator to determine whether the battery performance meets the requirements of the vehicle or not. Therefore, an evaluation of the state of health of a battery cannot be minimized.

Many vehicles available in the market do not have the function of determining the state of health of a battery in the early stage of battery management system design because of the complexity in determining the state of health of the battery. A determination method of the state of health of a battery is always being studied in the battery management system design because of the increasing importance of the state of health and the life of the battery.

WO 2015/025212 A1 relates to a technique for estimating a full charge capacity of an electric storage device that is installed on a vehicle and supplies power to a drive motor.

US 2012/296586 A1 discloses a method for diagnosing the state of health of a battery . The method comprises determining a first state-of-charge value from the battery voltage during partial discharge at constant current, determining a second state-of-charge value from the open circuit voltage of the battery, and calculating the state of health from the difference between the first and second state-of-charge values.

US 2003/214303 A1 discloses a method and apparatus to determine the state of charge (SOC) of a lead-acid battery operating in a hybrid electric vehicle (HEV).

At present, there are two ways for determining the state of health of a battery in a battery management system. These two ways are listed below.

1. Based on a cycle number: an inherent cycle number of a battery of the same supplier, the same batch, and the same battery type is tested in a laboratory as a baseline value. In the subsequent process of using the battery of the same supplier, the same batch, and the same battery type, an existing cycle number of the battery is recorded by the battery management system. The existing cycle number is subtracted from the inherent cycle number of the battery, and then divided by the inherent cycle number to obtain a current state of health of the battery. This method of determining the state of health of the battery is not very practical, and is merely applied to the battery of the same supplier, the same type and the same batch. Moreover, the tested baseline cycle number for the method is obtained in the experiment, which is generally performed by testing a battery cell. Test conditions are to simulate vehicle conditions, which cause a relatively larger error compared with actual operating conditions of the battery system. In addition, it is difficult for the battery management system to accumulate the existing cycle number of the battery system. Especially, for a hybrid power system, there is no complete charge and discharge cycle, and an accumulation error is also relatively large.

2. Determination based on an internal resistance: when a battery system leaves a factory, an internal resistance of the battery system is computed. The internal resistance of the battery changes as the battery is used over time. The state of health of the battery is determined based on the change of the internal resistance of the battery. It is difficult to determine the state of the health of the battery by using this method because, first of all, it is difficult to compute the internal resistance of the battery, and an error is relatively large due to the influence of temperature, charge-discharge rate and other factors. In addition, even if the internal resistance is determined, it is difficult to derive an accurate corresponding relationship between the internal resistance of the battery and the state of health of the battery system.

## SUMMARY

The objective of the present disclosure is to provide a method for estimating a service capacity of a minimum battery cell, so as to solve the existing problem of an inaccurate estimation of the service capacity of the minimum battery cell in the prior art. The present disclosure also provides a method for estimating a service capacity of a battery system, so as to solve the existing problem of an inaccurate estimation of the service capacity of the battery system in the prior art. The present disclosure also provides a method for estimating a state of health of a battery system, so as to solve the existing problem of an inaccurate estimation of the state of the health of the battery system. The present disclosure also provides a device for estimating a state of health of a battery system, so as to implement the method for estimating the state of health of the battery system, thereby solving the existing problem of the inaccurate estimation of the state of health of the battery system in the prior art.

To solve the aforementioned technical issues, the technical solutions of the present disclosure are as follows.

According to independent claim 1, the present disclosure provides a method for estimating a service capacity of a minimum battery cell in a battery system comprising a plurality of cells connected in series, wherein the minimum battery cell has a lowest voltage level among the plurality of cells. According to the method, when a battery system is power-on, an initial state of charge of the minimum battery cell, in the battery system being charged, is determined. Once the battery system is fully charged, a final state of charge of the minimum battery cell, at the end of charging, is determined. Thereafter, a charging capacity of the minimum battery cell is calculated based on the initial state and the final state of charge. Further, a service capacity of the minimum battery cell is determined according to the initial state of charge of the minimum battery cell, the state of charge of the minimum battery cell at the end of charging, the charging capacity and a rated capacity of the minimum battery cell.

Further, the initial state of charge of the minimum battery cell and the state of charge of the minimum battery cell at the end of charging are both determined by an open-circuit voltage method.

Further, the service capacity of the minimum battery cell is:

$$Q_d = \frac{Q_1 + Q_n * (1 - SOC_2)}{1 - SOC_1}$$

where, $Q_d$ is the service capacity of the minimum battery cell, $Q_1$ is the charging capacity, $Q_n$ is the rated capacity of the minimum battery cell, $SOC_1$ is the initial state of charge of the minimum battery cell, $SOC_2$ is the state of charge of the minimum battery cell at the end of charging.

The present disclosure also provides a method for determining a service capacity of a battery system based on the service capacity of the minimum battery cell, the rated capacity of the minimum battery cell, the state of charge of the minimum battery cell at the end of charging.

Further, the service capacity of the battery system is:

$$Q_s = Q_d - Q_n * (1 - SOC_2)$$

where, $Q_s$ is the service capacity of the battery system, $Q_d$ is the service capacity of the minimum battery cell, $Q_n$ is the rated capacity of the minimum battery cell, $SOC_2$ is the state of charge of the minimum battery cell at the end of charging.

The present disclosure also provides a method for estimating a state of health of a battery system based on the service capacity of the battery system and the rated capacity of the minimum battery cell.

Further, the state of health of the battery system is:

$$SOH = \frac{Q_s}{Q_n}$$

where, SOH is the state of health of the battery system, $Q_s$ is the service capacity of the battery system, $Q_n$ is the rated

capacity of the minimum battery cell.

Further, the method further includes the step of determining whether a difference between a current computed state of health of the battery system and a previous computed state of health of the battery system is greater than a set value, and if it is, the current computed state of health of the battery system is discarded.

According to independent claim 6, the present disclosure also provides a device for estimating a service capacity of a minimum battery cell in a battery system comprising a plurality of cells connected in series, wherein the minimum battery cell has a lowest voltage level among the plurality of cells, including a memory and a processor, wherein the processor is used to execute instructions stored in the memory to implement the following method. According to the method, when a battery system is power-on, an initial state of charge of the minimum battery cell, in the battery system being charged, is determined. Once the battery system is fully charged, a final state of charge of the minimum battery cell, at the end of charging, is determined. Thereafter, a charging capacity of the minimum battery cell is calculated based on the initial state and the final state of charge. Further, a service capacity of the minimum battery cell is determined according to the initial state of charge of the minimum battery cell, the state of charge of the minimum battery cell at the end of charging, the charging capacity and a rated capacity of the minimum battery cell. Further, the initial state of charge of the minimum battery cell and the state of charge of the minimum battery cell at the end of charging are both determined by an open-circuit voltage method.

Further, the service capacity of the minimum battery cell is:

$$Q_d = \frac{Q_1 + Q_n * (1 - SOC_2)}{1 - SOC_1}$$

where, $Q_d$ is the service capacity of the minimum battery cell, $Q_1$ is the charging capacity, $Q_n$ is the rated capacity of the minimum battery cell, $SOC_1$ is the initial state of charge of the minimum battery cell, $SOC_2$ is the state of charge of the minimum battery cell at the end of charging.

The present disclosure also provides a device for estimating a service capacity of a battery system based on the service capacity of the minimum battery cell, the rated capacity of the minimum battery cell, the state of charge of the minimum battery cell at the end of charging.

Further, the service capacity of the battery system is:

$$Q_s = Q_d - Q_n * (1 - SOC_2)$$

where, $Q_s$ is the service capacity of the battery system, $Q_d$ is the service capacity of the minimum battery cell, $Q_n$ is the rated capacity of the minimum battery cell, $SOC_2$ is the state of charge of the minimum battery cell at the end of charging.

The present disclosure also provides a device for estimating a state of health of a battery system based on the service capacity of the battery system and the rated capacity of the minimum battery cell.

Further, the state of health of the battery system is:

$$SOH = \frac{Q_s}{Q_n}$$

where, SOH is the state of health of the battery system, $Q_s$ is the service capacity of the battery system, $Q_n$ is the rated capacity of the minimum battery cell.

Further, the method further includes the step of determining whether a difference between a current computed state of health of the battery system and a previous computed state of health of the battery system is greater than a set value, and if it is, the current computed state of health of the battery system is discarded.

Advantages of the present disclosure:

The method for estimating the service capacity of the minimum battery cell of the present disclosure can accurately obtain the service capacity of a battery cell.

The method for estimating the service capacity of the battery system of the present disclosure is based on cask effect, selecting a minimum battery cell as a research object. The service capacity of the battery system is computed by calculating the service capacity of the minimum battery cell, thereby avoiding the problem that the computed service capacity does not reflect a real state of the system due to an inaccuracy of a selected object.

The method for estimating the state of health of the battery system of the present disclosure is based on the aforementioned method for estimating the service capacity of the battery system, more intuitively reflecting the degree of attenuation and the state of health of the battery, effectively solving the problem of inaccurate estimation of the state of health of the vehicle battery system, and overcoming the shortcomings of determination of the state of health of the battery based on the internal resistance method and cycle number method.

The device for estimating the state of health of the battery system of the present disclosure is used for implementing the method for estimating the state of health of the battery system, effectively solving the problem of inaccurate estimation of the state of health of the vehicle battery system, and overcoming the shortcomings in determination of the state of health of the battery based on the internal resistance method and cycle number method.

## BRIEF DESCRIPTION OF THE DRAWINGS

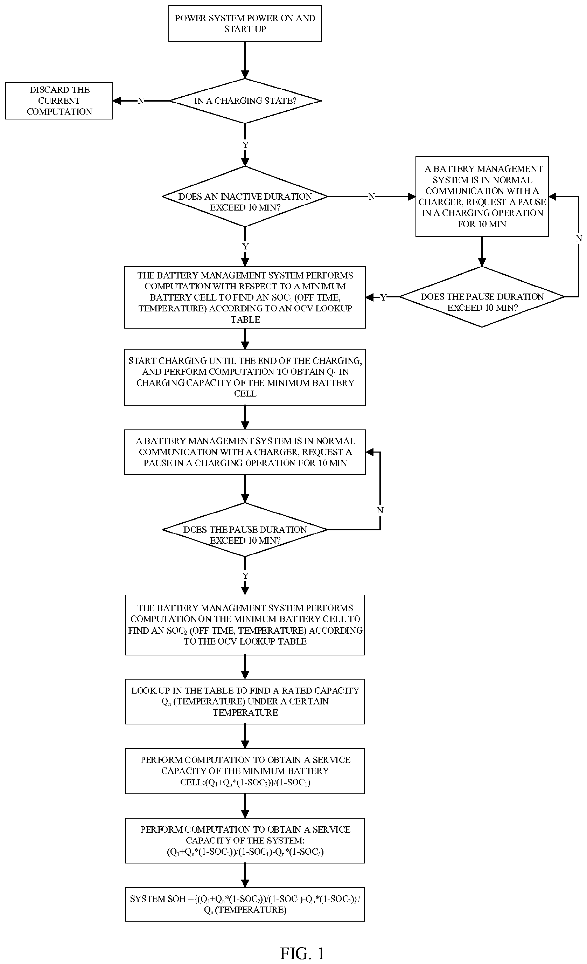

FIG. 1 is a flow chart of a method for estimating a state of health of a battery system of the present disclosure.

## DETAILED DESCRIPTION OF THE EMBODIMENTS

In order to make the objectives, technical solutions and advantages of the present disclosure more clear, the present disclosure will be further described in detail below in conjunction with the drawing and embodiments.

Embodiment of a method for estimating a service capacity of a minimum battery cell of the present disclosure:

A whole battery system consists of battery cells connected in series. After the battery system is powered on, firstly, judging whether the battery system is in a charging state. If it is in a non-charging state, a current computation will be abandoned; otherwise, the minimum battery cell in the battery system is selected as a research object to compute a service capacity of the minimum battery cell.

The minimum battery cell of the system is judged based on a voltage of the battery cell. In the application process of the whole system, a potential shown by the battery cell is the voltage of the battery cell. The voltage of the battery cell has a usable range, the usable range of lithium iron phosphate is between 2.5 and 3.65 volts, and the whole system cannot work if a voltage of a certain battery cell is less than 2.5 volts.

To compute a service capacity of the minimum battery cell, an initial state of charge $SOC_1$ of the minimum battery cell is first determined; after the battery system is fully charged, a state of charge $SOC_2$ of the minimum battery cell at the end of charging is determined, and a charging capacity $Q_1$ during a charging time is calculated; and then, according to a rated capacity $Q_n$ of the minimum battery cell, the service capacity $Q_d$ of the minimum battery cell can be obtained:

$$Q_d = \frac{Q_1 + Q_n * (1 - SOC_2)}{1 - SOC_1}$$

Due to the estimation error of SOC during the driving process of the vehicle, the SOC displayed by the system at that time cannot be regarded as the real SOC of the minimum battery cell. It is necessary to correct the SOC of the minimum battery cell in the battery system, and make another accurate estimation. An open circuit voltage look-up table method can be used to determine the real SOC of the minimum battery cell in the battery system. In order to achieve accurate correspondence between the SOC and the open circuit voltage (OCV), in this embodiment, an inactive duration is required to be more than 10 minutes, and the corresponding relationship between the SOC and the OCV is obtained under this condition with an interval of 2 minutes.

In order to obtain a more accurate SOC value, when using the open-circuit voltage method, a voltage value of the minimum battery cell shall be a stable value, that is, an open-circuit voltage value of the minimum battery cell measured at the moment shall be an open-circuit voltage value measured after the battery is put at rest for a while. Therefore, in this embodiment, it is necessary to judge whether the inactive duration exceeds 10 minutes before determining the initial state of charge $SOC_1$ of the minimum battery cell according to the open-circuit voltage method to ensure an accurate correspondence between the OCV and the SOC in the case of no load. If the inactive duration does not exceed 10 minutes, the battery management system requests to pause for being charged for 10 minutes. Similarly, before determining the state of charge $SOC_2$ of the minimum battery cell at the end of charging according to the open-circuit voltage method, the battery system shall also be in a state where the inactive duration exceeds 10 minutes after the battery is fully charged. If the inactive duration does not exceed 10 minutes, the battery management system requests to pause for being charged for 10 minutes.

In addition, since the service capacity of the same battery varies greatly under different temperatures, judging the state of charging SOC of the battery by the present disclosure is performed based on a same temperature. Moreover, the rated capacity of the battery is also affected by the temperature, so the rated capacity of the minimum battery cell of the battery system must be a rated capacity computed at the same temperature at which the SOC is calculated.

It should be noted that if it is not fully charged, the computation is abandoned.

In the above embodiment, the open-circuit voltage method is used to determine the initial state of charge of the minimum battery cell in the battery system and the state of charge of the minimum battery cell in the battery system at the end of charging, making the state of charge of the minimum battery cell relatively accurate. Thus, the service capacity of the minimum battery cell can be computed more accurately.

Embodiment of a method for estimating a service capacity of a battery system of the present disclosure:

The service capacity of the battery system refers to a capacity of an entire battery pack at a specific temperature. The method for estimating the service capacity of the battery system of the present disclosure is based on the aforementioned method for estimating the service capacity of the minimum battery cell to perform the estimation of the service capacity of the battery system.

The service capacity of the system is based on the service capacity of the minimum battery cell. The reason is that in a process of using the power system, based on cask effect, the battery life will be terminated according to the capacity of the minimum battery cell. Therefore, after calculating the service capacity of the minimum battery cell, it is necessary to remove the consistency effect, that is:

$$Q_n * (1 - SOC_2)$$

where, $Q_n$ is a rated capacity of the minimum battery cell, $SOC_2$ is the state of charge of the minimum battery cell at the end of charging.

Then, the service capacity $Q_s$ of the battery system is:

$$Q_s = Q_d - Q_n * (1 - SOC_2) = \frac{Q_1 + Q_n * (1 - SOC_2)}{1 - SOC_1} - Q_n * (1 - SOC_2)$$

where, $Q_s$ is the service capacity of the battery system, $Q_d$ is the service capacity of the minimum battery cell, $Q_n$ is the rated capacity of the minimum battery cell, $SOC_2$ is the state of charge of the minimum battery cell at the end of charging, $SOC_1$ is the initial state of charge of the minimum battery cell.

Embodiment of a method for estimating a state of health of a battery system of the present disclosure:

The state of health (SOH) of the battery is a core algorithm of the battery management system. The method for estimating the state of health of the battery system of the present disclosure is mainly based on the service capacity of the system to compute the state of health of the whole battery system. A flow chart of the method for estimating the SOH of the present disclosure is shown in FIG. 1.

Based on the service capacity of the battery system computed above, the state of health of the battery system can be finally computed according to the rated capacity of the minimum battery cell. The power system consists of battery cells connected in series, and the protection and use of the battery cell are determined according to parameters of the minimum battery cell. According to cask effect, the whole power system cannot be used when the life of the minimum battery cell is terminated.

Then, the state of health of the battery system is:

$$SOH = \frac{Q_s}{Q_n} = \frac{\frac{Q_1 + Q_n * (1 - SOC_2)}{1 - SOC_1} - Q_n * (1 - SOC_2)}{Q_n}$$

where, SOH is the state of health of the battery system, $Q_s$ is the service capacity of the battery system, $Q_n$ is the rated capacity of the minimum battery cell, $Q_1$ is the charging capacity, $SOC_2$ is the state of charge of the minimum battery cell at the end of charging, $SOC_1$ is the initial state of charge of the minimum battery cell.

After calculating the state of health SOH of the system, the output result needs to be verified. Considering that there is a problem with the minimum battery cell in the system, the computation result will surely have a large error, which needs to be eliminated. For example, the SOH of the battery system is gradually changing, and there will be no large jumps. If a difference between the current computed SOH and the previous stored SOH is more than 3 points, the current computed SOH is discarded.

In order to implement the method for estimating the service capacity of the minimum battery cell, the method for estimating the service capacity of the battery system, and the method for estimating the state of health of the battery system, the present disclosure accordingly provides a device for estimating the service capacity of the minimum battery cell, a device for estimating the service capacity of the battery system, and a device for estimating the state of health of the battery system. Each device includes a memory and a processor. Instructions are stored in the memory for coding their corresponding methods to ensure that the corresponding methods can be implemented when the processor executes the instructions in the memory. The introduction of these three methods is sufficiently clear, and these devices will not be further described.

The present disclosure will be further explained below in conjunction with one specific example.

A new energy bus, where, a rated capacity of lithium iron phosphate battery system is 100 AH

1) When the battery system is powered on, a minimum battery cell is recorded as a NO.1 battery cell. When the battery system is detected in a charging state after startup, whether the inactive duration exceeds 10 minutes is judged. In the case that the inactive duration exceeds 10 minutes, an open circuit voltage is measured at this time, and the initial state of charge of the NO.1 battery cell is obtained according to an open-circuit voltage look-up table method, i.e., $SOC_1 = 20\%$.

2) In the case that the battery system is fully charged, the battery management system requests to pause for 10 minutes. After pausing for 10 minutes, measuring an open circuit voltage at this time, and according to the open-circuit voltage look-up table method, the state of charge of the NO.1 battery cell at the end of charging is obtained, i.e., $SOC_2 = 98\%$.

3) According to the aforementioned measured values, a service capacity $Q_d$ of the NO.1 battery cell is calculated as:

$$Q_d = \frac{Q_1 + Q_n * (1 - SOC_2)}{1 - SOC_1} = \frac{75 + 100 * (1 - 98\%)}{1 - 20\%} = 96.25\,\text{AH}$$

At this point, the service capacity of the minimum battery cell is finally computed.

If it is necessary to compute the service capacity of the battery system, based on the aforementioned computations, according to the state of charge $SOC_2$ of the minimum battery cell at the end of charging and the rated capacity $Q_n$ of the minimum battery cell, the service capacity $Q_d$ of the battery system can be computed, that is:

$$Q_s = Q_d - Q_n * (1 - SOC_2) = 96.25 - 100 * (1 - 98\%) = 94.25\,\text{AH}$$

At this point, the service capacity of the battery system is finally computed.

If it is necessary to compute the state of health of the battery system, based on the aforementioned computations, according to the rated capacity $Q_n$ of the minimum battery cell, the state of health SOH of the battery system can be computed, that is:

$$\text{SOH} = \frac{Q_s}{Q_n} = \frac{94.25}{100} = 94.25\%$$

Similarly, the SOH of ternary battery and the SOH of the plug-in battery system can be computed.

**Claims**

1. A method for estimating a service capacity of a minimum battery cell in a battery system comprising a plurality of cells connected in series, wherein the minimum battery cell has a lowest voltage level among the plurality of cells, comprising the following steps:

when a battery system is power-on, determining an initial state of charge, $SOC_1$, of the minimum battery cell in a battery system being charged;

after the battery system is fully charged, determining a final state of charge, $SOC_2$, of the minimum battery cell at an end of charging, and calculating to obtain a charging capacity, $Q_1$, of the minimum battery cell based on the initial state of charge, $SOC_1$, and the final state of charge, $SOC_2$; and

performing a computation to obtain the service capacity, $Q_d$, of the minimum battery cell based on following equation:

$$Q_d = \frac{Q_1 + Q_n * (1 - SOC_2)}{1 - SOC_1}$$

wherein $Q_n$ is a rated capacity of the minimum battery cell.

2. The method of claim 1 further comprising determining a service capacity of the battery system based on the service capacity of the minimum battery cell, the rated capacity of the minimum battery cell and the final state of charge of the minimum battery cell at the end of charging.

3. The method of claim 2, wherein, the service capacity of the battery system is:

$$Q_s = Q_d - Q_n * (1 - SOC_2)$$

where, $Q_s$ is the service capacity of the battery system, $Q_d$ is the service capacity of the minimum battery cell, $Q_n$ is the rated capacity of the minimum battery cell, $SOC_2$ is the state of charge of the minimum battery cell at the end of charging.

4. The method of claim 3 further comprising determining a state of health of the battery system based on the service capacity of the battery system and the rated capacity of the minimum battery cell.

5. The method of claim 4, wherein the state of health of the battery system is:

$$SOH = \frac{Q_s}{Q_n}$$

where, SOH is the state of health of the battery system, $Q_s$ is the service capacity of the battery system, $Q_n$ is the rated capacity of the minimum battery cell.

6. A device for estimating a service capacity of a minimum battery cell in a battery system comprising a plurality of cells connected in series, wherein the minimum battery cell has a lowest voltage level among the plurality of cells, comprising a memory and a processor, wherein the processor is configured to execute instructions stored in the memory to implement the following method:

when a battery system is power-on, determining an initial state of charge, $SOC_1$, of the minimum battery cell in the battery system being charged;

after the battery system is fully charged, determining a final state of charge, $SOC_2$, of the minimum battery cell at an end of charging, and calculating to obtain a charging capacity, $Q_1$, of the minimum battery cell based on the initial state of charge, $SOC_1$, and the final state of charge, $SOC_2$; and

performing a computation to obtain the service capacity, $Q_d$, of the minimum battery cell based on following equation:

$$Q_d = \frac{Q_1 + Q_n * (1 - SOC_2)}{1 - SOC_1}$$

wherein Q$_n$ is a rated capacity of the minimum battery cell.

7. The device of claim 6, wherein the processor is configured to determining a service capacity of a battery system based on the service capacity of the minimum battery cell, the rated capacity of the minimum battery cell and the final state of charge of the minimum battery cell at the end of charging.

8. The device of claim 7, wherein the service capacity of the battery system is:

$$Q_s = Q_d - Q_n * (1 - SOC_2)$$

where, Q$_s$ is the service capacity of the battery system, Q$_d$ is the service capacity of the minimum battery cell, Q$_n$ is the rated capacity of the minimum battery cell, SOC$_2$ is the state of charge of the minimum battery cell at the end of charging.

9. The device of claim 8, wherein the processor is configured to determine a state of health of the battery system based on the service capacity of the battery system and the rated capacity of the minimum battery cell.

10. The device of claim 9, wherein the state of health of the battery system is:

$$SOH = \frac{Q_s}{Q_n}$$

where, SOH is the state of health of the battery system, Q$_s$ is the service capacity of the battery system, Q$_n$ is the rated capacity of the minimum battery cell.

**Patentansprüche**

1. Verfahren zur Schätzung einer Dienstkapazität einer Zelle mit minimaler Spannung in einem Batteriesystem, das eine Mehrzahl in Reihe geschalteter Zellen umfasst, wobei die Zelle mit minimaler Spannung unter der Mehrzahl von Zellen einen niedrigsten Spannungspegel aufweist, umfassend die folgenden Schritte:

wenn ein Batteriesystem eingeschaltet ist, Bestimmen eines Anfangsladezustands SOC$_1$ der Zelle mit minimaler Spannung in einem Batteriesystem, das geladen wird;
nachdem das Batteriesystem vollständig geladen ist, Bestimmen eines Endladezustands SOC$_2$ der Zelle mit minimaler Spannung bei einem Ende des Ladevorgangs, und Errechnen einer Ladekapazität Q$_1$ der Zelle mit minimaler Spannung auf der Grundlage des Anfangsladezustands SOC$_1$ und des Endladezustands SOC$_2$; und
Durchführen einer Berechnung der Dienstkapazität Q$_d$ der Zelle mit minimaler Spannung auf der Grundlage folgender Gleichung:

$$Q_d = \frac{Q_1 + Q_n * (1 - SOC_2)}{1 - SOC_1}$$

wobei Q$_n$ eine Nennkapazität der Zelle mit minimaler Spannung ist.

2. Verfahren nach Anspruch 1, ferner umfassend Bestimmen einer Dienstkapazität des Batteriesystems auf der Grundlage der Dienstkapazität der Zelle mit minimaler Spannung, der Nennkapazität der Zelle mit minimaler Spannung und des Endladezustands der Zelle mit minimaler Spannung beim Ende des Ladevorgangs.

3. Verfahren nach Anspruch 2, wobei die Dienstkapazität des Batteriesystems Folgendes ist:

$$Q_s = Q_d - Q_n * (1 - SOC_2)$$

wobei $Q_s$ die Dienstkapazität des Batteriesystems ist, $Q_d$ die Dienstkapazität der Zelle mit minimaler Spannung ist, $Q_n$ die Nennkapazität der Zelle mit minimaler Spannung ist, $SOC_2$ der Ladezustand der Zelle mit minimaler Spannung beim Ende des Ladevorgangs ist.

4. Verfahren nach Anspruch 3, ferner umfassend Bestimmen eines Gesundheitszustandes des Batteriesystems auf der Grundlage der Dienstkapazität des Batteriesystems und der Nennkapazität der Zelle mit minimaler Spannung.

5. Verfahren nach Anspruch 4, wobei der Gesundheitszustand des Batteriesystems Folgendes ist:

$$\text{SOH} = \frac{Q_s}{Q_n}$$

wobei SOH der Gesundheitszustand des Batteriesystems ist, $Q_s$ die Dienstkapazität des Batteriesystems ist, $Q_n$ die Nennkapazität der Zelle mit minimaler Spannung ist.

6. Vorrichtung zur Schätzung einer Dienstkapazität einer Zelle mit minimaler Spannung in einem Batteriesystem, das eine Mehrzahl in Reihe geschalteter Zellen umfasst, wobei die Zelle mit minimaler Spannung unter der Mehrzahl von Zellen einen niedrigsten Spannungspegel aufweist, umfassend einen Speicher und einen Prozessor, wobei der Prozessor dazu konfiguriert ist, in dem Speicher gespeicherte Befehle auszuführen, um das folgende Verfahren zu implementieren:

wenn ein Batteriesystem eingeschaltet ist, Bestimmen eines Anfangsladezustands $SOC_1$ der Zelle mit minimaler Spannung in dem Batteriesystem, das geladen wird;
nachdem das Batteriesystem vollständig geladen ist, Bestimmen eines Endladezustands $SOC_2$ der Zelle mit minimaler Spannung bei einem Ende des Ladevorgangs, und Errechnen einer Ladekapazität $Q_1$ der Zelle mit minimaler Spannung auf der Grundlage des Anfangsladezustands $SOC_1$ und des Endladezustands $SOC_2$; und Durchführen einer Berechnung der Dienstkapazität $Q_d$ der Zelle mit minimaler Spannung auf der Grundlage folgender Gleichung:

$$Q_d = \frac{Q_1 + Q_n * (1 - SOC_2)}{1 - SOC_1}$$

wobei $Q_n$ eine Nennkapazität der Zelle mit minimaler Spannung ist.

7. Vorrichtung nach Anspruch 6, wobei der Prozessor dazu konfiguriert ist, eine Dienstkapazität eines Batteriesystems zu bestimmen auf der Grundlage der Dienstkapazität der Zelle mit minimaler Spannung, der Nennkapazität der Zelle mit minimaler Spannung und des Endladezustands der Zelle mit minimaler Spannung beim Ende des Ladevorgangs.

8. Vorrichtung nach Anspruch 7, wobei die Dienstkapazität des Batteriesystems Folgendes ist:

$$Q_s = Q_d - Q_n * (1 - SOC_2)$$

wobei $Q_s$ die Dienstkapazität des Batteriesystems ist, $Q_d$ die Dienstkapazität der Zelle mit minimaler Spannung ist, $Q_n$ die Nennkapazität der Zelle mit minimaler Spannung ist, $SOC_2$ der Ladezustand der Zelle mit minimaler Spannung beim Ende des Ladevorgangs ist.

9. Vorrichtung nach Anspruch 8, wobei der Prozessor dazu konfiguriert ist, einen Gesundheitszustand des Batteriesystems zu bestimmen auf der Grundlage der Dienstkapazität des Batteriesystems und der Nennkapazität der Zelle mit minimaler Spannung.

10. Vorrichtung nach Anspruch 9, wobei der Gesundheitszustand des Batteriesystems Folgendes ist:

$$SOH = \frac{Q_s}{Q_n}$$

wobei SOH der Gesundheitszustand des Batteriesystems ist, $Q_s$ die Dienstkapazität des Batteriesystems ist, $Q_n$ die Nennkapazität der Zelle mit minimaler Spannung ist.

**Revendications**

1. Procédé pour l'estimation d'une capacité de service d'une cellule à tension minimum dans un système de batterie comprenant une pluralité de cellules connectées en série, la cellule à tension minimum ayant le plus bas niveau de tension parmi la pluralité de cellules, comprenant les étapes suivantes :

   lorsqu'un système de batterie est allumé, déterminer un état de charge initial, $SOC_1$, de la cellule à tension minimum dans un système de batterie étant chargé ;
   après que le système de batterie est entièrement chargé, déterminer un état de charge final, $SOC_2$, de la cellule à tension minimum, à la fin de la charge, et effectuer un calcul pour obtenir une capacité de charge, $Q_1$, de la cellule à tension minimum sur la base de l'état de charge initial, $SOC_1$, et de l'état de charge final, $SOC_2$ ; et effectuer un calcul pour obtenir la capacité de service, $Q_d$, de la cellule à tension minimum, sur la base de l'équation suivante :

$$Q_d = \frac{Q_1 + Q_n * (1 - SOC_2)}{1 - SOC_1}$$

   $Q_n$ étant une capacité nominale de la cellule à tension minimum.

2. Procédé selon la revendication 1, comprenant en outre déterminer une capacité de service du système de batterie sur la base de la capacité de service de la cellule à tension minimum, de la capacité nominale de la cellule à tension minimum et de l'état de charge final de la cellule à tension minimum à la fin de la charge.

3. Procédé selon la revendication 2, la capacité de service du système de batterie étant :

$$Q_s = Q_d - Q_n * (1 - SOC_2)$$

   $Q_s$ étant la capacité de service du système de batterie, $Q_d$ étant la capacité de service de la cellule à tension minimum, $Q_n$ étant la capacité nominale de la cellule à tension minimum, $SOC_2$ étant l'état de charge final de la cellule à tension minimum à la fin de la charge.

4. Procédé selon la revendication 3, comprenant en outre déterminer un état de santé du système de batterie sur la base de la capacité de service du système de batterie et de la capacité nominale de la cellule à tension minimum.

5. Procédé selon la revendication 4, l'état de santé du système de batterie étant :

$$SOH = \frac{Q_s}{Q_n}$$

   SOH étant l'état de santé du système de batterie, $Q_s$ étant la capacité de service du système de batterie, $Q_n$ étant la capacité nominale de la cellule à tension minimum.

6. Dispositif pour l'estimation d'une capacité de service d'une cellule à tension minimum dans un système de batterie comprenant une pluralité de cellules connectées en série, la cellule à tension minimum ayant le plus bas niveau de tension parmi la pluralité de cellules, comprenant une mémoire et un processeur, le processeur étant configuré pour exécuter des instructions enregistrées dans la mémoire pour appliquer le procédé suivant :

lorsqu'un système de batterie est allumé, déterminer un état de charge initial, $SOC_1$, de la cellule à tension minimum dans le système de batterie étant chargé ;

après que le système de batterie est entièrement chargé, déterminer un état de charge final, $SOC_2$, de la cellule à tension minimum à la fin de la charge, et effectuer un calcul pour obtenir une capacité de charge, $Q_1$, de la cellule à tension minimum sur la base de l'état de charge initial, $SOC_1$, et de l'état de charge final, $SOC_2$ ; et effectuer un calcul pour obtenir la capacité de service, $Q_d$, de la cellule à tension minimum, sur la base de l'équation suivante :

$$Q_d = \frac{Q_1 + Q_n * (1 - SOC_2)}{1 - SOC_1}$$

$Q_n$ étant une capacité nominale de la cellule à tension minimum.

7. Dispositif selon la revendication 6, le processeur étant configuré pour déterminer une capacité de service d'un système de batterie sur la base de la capacité de service de la cellule à tension minimum, de la capacité nominale de la cellule à tension minimum et de l'état de charge final de la cellule à tension minimum à la fin de la charge.

8. Dispositif selon la revendication 7, la capacité de service du système de batterie étant :

$$Q_s = Q_d - Q_n * (1 - SOC_2)$$

$Q_s$ étant la capacité de service du système de batterie, $Q_d$ étant la capacité de service de la cellule à tension minimum, $Q_n$ étant la capacité nominale de la cellule à tension minimum, $SOC_2$ étant l'état de charge final de la cellule à tension minimum à la fin de la charge.

9. Dispositif selon la revendication 8, le processeur étant configuré pour déterminer un état de santé du système de batterie sur la base de la capacité de service du système de batterie et de la capacité nominale de la cellule à tension minimum.

10. Dispositif selon la revendication 9, l'état de santé du système de batterie étant :

$$SOH = \frac{Q_s}{Q_n}$$

SOH étant l'état de santé du système de batterie, $Q_s$ étant la capacité de service du système de batterie, $Q_n$ étant la capacité nominale de la cellule à tension minimum.

POWER SYSTEM POWER ON AND START UP

IN A CHARGING STATE? —N→ DISCARD THE CURRENT COMPUTATION

↓Y

DOES AN INACTIVE DURATION EXCEED 10 MIN? —N→ A BATTERY MANAGEMENT SYSTEM IS IN NORMAL COMMUNICATION WITH A CHARGER, REQUEST A PAUSE IN A CHARGING OPERATION FOR 10 MIN

↓Y

THE BATTERY MANAGEMENT SYSTEM PERFORMS COMPUTATION WITH RESPECT TO A MINIMUM BATTERY CELL TO FIND AN $SOC_1$ (OFF TIME, TEMPERATURE) ACCORDING TO AN OCV LOOKUP TABLE ←Y— DOES THE PAUSE DURATION EXCEED 10 MIN? ↑N

START CHARGING UNTIL THE END OF THE CHARGING, AND PERFORM COMPUTATION TO OBTAIN $Q_1$ IN CHARGING CAPACITY OF THE MINIMUM BATTERY CELL

A BATTERY MANAGEMENT SYSTEM IS IN NORMAL COMMUNICATION WITH A CHARGER, REQUEST A PAUSE IN A CHARGING OPERATION FOR 10 MIN

DOES THE PAUSE DURATION EXCEED 10 MIN? —N↑

↓Y

THE BATTERY MANAGEMENT SYSTEM PERFORMS COMPUTATION ON THE MINIMUM BATTERY CELL TO FIND AN $SOC_2$ (OFF TIME, TEMPERATURE) ACCORDING TO THE OCV LOOKUP TABLE

LOOK UP IN THE TABLE TO FIND A RATED CAPACITY $Q_n$ (TEMPERATURE) UNDER A CERTAIN TEMPERATURE

PERFORM COMPUTATION TO OBTAIN A SERVICE CAPACITY OF THE MINIMUM BATTERY CELL: $(Q_1 + Q_n*(1-SOC_2))/(1-SOC_1)$

PERFORM COMPUTATION TO OBTAIN A SERVICE CAPACITY OF THE SYSTEM: $(Q_1 + Q_n*(1-SOC_2))/(1-SOC_1) - Q_n*(1-SOC_2)$

SYSTEM SOH $= \{(Q_1 + Q_n*(1-SOC_2))/(1-SOC_1) - Q_n*(1-SOC_2)\}/ Q_n$ (TEMPERATURE)

FIG. 1

**EP 3 594 705 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2015025212 A1
- US 2012296586 A1
- US 2003214303 A1

**Non-patent literature cited in the description**

- China Energy-Saving and New Energy Vehicles Industry Development Program (2012-2020). General Office of the State Council, 2012